# EUROPEAN PATENT SPECIFICATION

(11) **EP 0 608 579 B1**
(45) Date of publication and mention of the grant of the patent: **16.04.1997**
(21) Application number: 93200234.8
(22) Date of filing: 29.01.1993
(51) Int. Cl.: B41M 5/30

(54) **A heat and light sensitive imaging element**
Wärme- und lichtempfindliches Aufzeichnungselement
Elément formateur d'image sensible à la chaleur et à la lumière

(43) Date of publication of application: 03.08.1994
(73) Proprietor: AGFA-GEVAERT naamloze vennootschap, B-2640 Mortsel (BE)
(72) Inventor: Podszun, Wolfgang, B-2640 Mortsel (BE); Mueller, Michael, B-2640 Mortsel (BE); Uytterhoeven, Herman Jozef, B-2640 Mortsel (BE)

(56) References cited:
- EP-A- 0 122 468
- EP-A- 0 234 540
- EP-A- 0 424 914
- EP-A- 0 439 369

## Description

### 1. Field of the invention.

The present invention relates to an imaging element that can be imaged by means of heat or that can be imaged by exposure to an image-wise pattern of actinic radiation.

### 2. Background of the invention.

Heat sensitive recording materials are well known and generally offer more convenience than other imaging systems besides an ecological advantage. Among heat sensitive recording materials there are known, thermal transfer system in which an image forming substance e.g. a dye is image-wise transferred from a donor element to a receiving element upon the application of heat, heat mode recording materials in which a heat pattern causes a change in e.g. the adhesion of an image-forming substance which can subsequently be employed to develop the image, recording materials where, upon exposure with a powerful laser, parts of an image-forming layer are burned away or destroyed etc...

A further well-known heat-sensitive recording material is based on a reaction between a dye-precursor and a colour-developer that can be initiated by the application of heat. Generally the dye-precursor is a leuco-dye and the colour-developer an organic acid or phenolic compound. In order to prevent premature colour formation the leuco-dye and colour-developer are arranged in separate layers or they can be both contained in one binder layer. In the latter case the binder is chosen such that its' softening temperature is well above ambient temperature and image-wise heating the binder layer will then cause local softening of the binder, so that reaction between the dye precursor and developer can take place.

Heat-sensitive recording materials based on leuco-dyes are very easy to use and are employed in, e.g., teleprinters, facsimiles, in recording and measuring instruments etc.. However, since leuco dye and colour developer remain present in unreacted form in the non-image areas of the imaging element the long-term storage-stability of the image is poor. Attempts have been made to improve the stability of the image by adding certain compounds as disclosed in e.g. US-P-4.473.831 and EP-A-252691 or by using specific developers as disclosed in e.g. US-P-4.531.139 and EP-A-269443.

EP-A-439369 discloses a heat sensitive recording material according to the preamble of Claim 1 comprising on a support a recording layer and a succinic compound included in the recording layer or an adjacent layer. The recording layer contains a color former and a developer that upon heating produce color.

### Object of Invention

It is an object of the invention to provide an imaging element that can be employed as a heat sensitive or as a light sensitive imaging element and that yields images of improved stability.

### Statement of Invention

According to the present invention there is provided an imaging element comprising a dye precursor and an acidic colour developer arranged on a support in the same layer or in separate layers characterised in that the acid developer includes at least 50% by weight polymerizable organic acid and the layer containing the polymerizable organic acid further includes a photoinitiator.

The organic acid is polymerizable through a free radical mechanism initiated by light.

Preferably the acid has a formula (I) 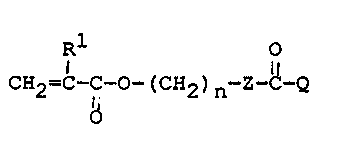 wherein R1 represents hydrogen or a methyl group, Z represents -O- or -NR- with R an alkyl group having 1 to 4 carbon atoms and Q represents an aromatic ring substituted with at least two -COOH groups and which carboxyl groups may be in the form of an anhydride.

The layer containing the polymerizable acid may also contain a polymerizable monomer.

### 4. Detailed description of the invention.

It has been found that by incorporating an acid developer according to formula (I) in a layer containing a dye precursor and/or a colour developer, an imaging element is obtained that can be imaged and stabilized according to one of the following methods:

According to a first method said imaging element is image-wise exposed to actinic radiation thereby causing polymerization of the acid in the exposed part so that as a consequence the colour developer is immobilized (or the diffusion of said compound(s) is at least substantially decreased) at these parts. The imaging element is then overall heated thereby causing reaction of the dye precursor and colour developer in the non-exposed areas so that a colour develops in the areas.

According to a second method said imaging element is image-wise exposed by heat thereby causing colour formation in the exposed areas and subsequently overall exposing said imaging element to actinic radiation so that the unreacted colour developer is polymerized and immobilized or the diffusion thereof is substantially decreased.

Image-wise exposure by actinic radiation or heat and overall exposure to respectively heat or actinic radiation in the above methods can also be carried out simultaneously in accordance with the present invention.

The exposure to actinic radiation can be a contact exposure using e.g ultraviolet radiation, a camera exposure, a scanning exposure, or a laser exposure. The radiation source used in carrying out the exposure step includes e.g. sunlight, incandescent lamps, mercury vapour lamps, halogen lamps, xenon lamps, fluorescent lamps, light-emitting diodes, lasers, electron rays, and X-rays.

Exposure of the imaging element to heat can be carried out by e.g. a thermal head, as e.g. in a thermal printer or by a laser. In the latter case the imaging element will preferably include a substance that is capable of converting the laser light to heat and the wavelength of the laser will be selected such that it will not cause polymerization of the acid in accordance with formula (I). In case of an overall exposure the heat can also be applied by guiding the element through a pair of rolls at least one of which is at an elevated temperature.

The images obtained according to one of the methods described above show an improved stability due to efficient immobilization of unreacted colour developer. Further a high light sensitivity of the imaging element was found.

The polymerizable acid developers are of the type illustrated in EP-A-0471252. Examples of which are :

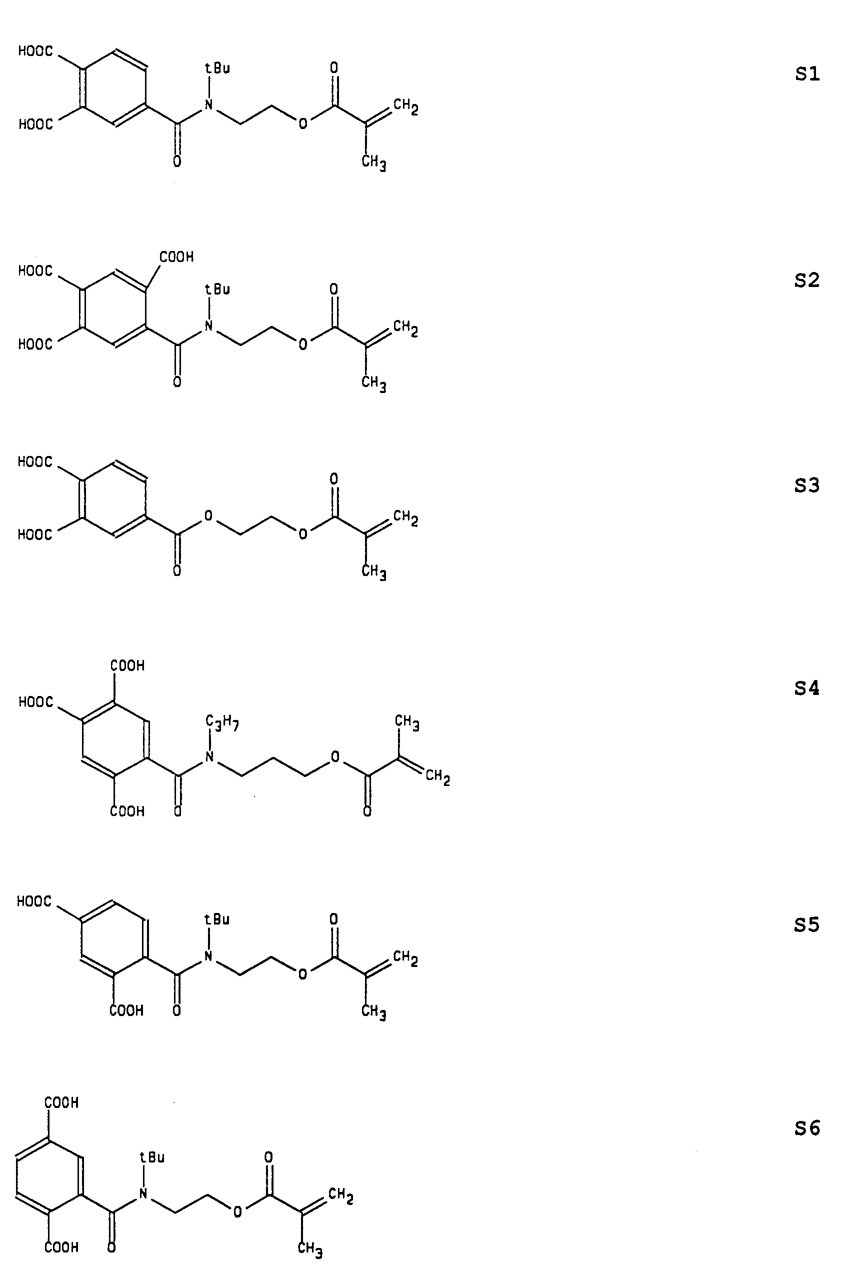

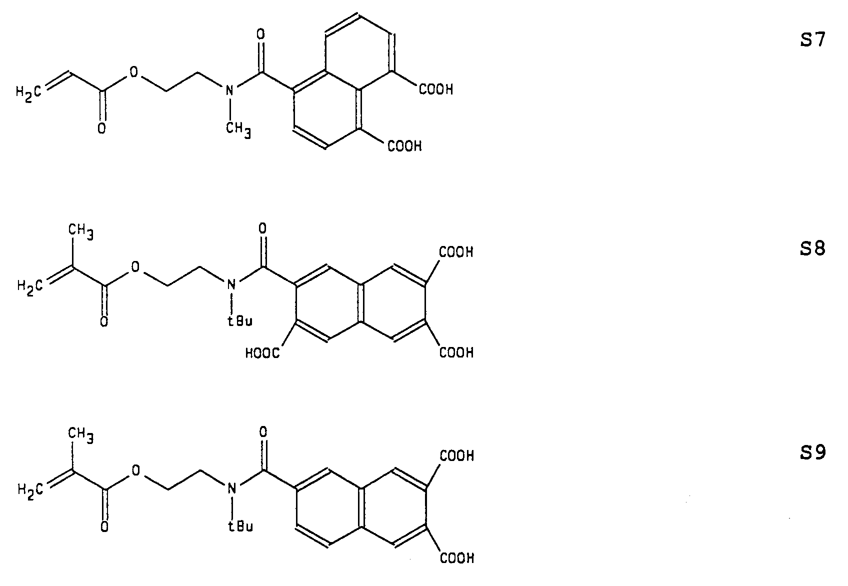

In the above formulas tBu represents a t-butyl group.

The choice of acid developer has little effect on the final colour of the dye precursor. Amongst the non polymerizable colour developers which may be added to the layer or layers together with the polymerizable acid developer to develop the colour by contacting the dye precursors, are for example:
Phenolic compounds such as 4-tert-butylphenol, α-naphthol, β-naphthol, 4-acetylphenol, 4-phenylphenol, hydroquinone, 4,4'-isopropylidenediphenol(bisphenol A), 2,2'-methylenebis(4-chlorophenol), 4,4'-cyclohexylidenediphenol, 4,4'-dihydroxydiphenylsulfide, hydroquinone monobenzyl ether, 4-hydroxybenzophenone, 2,4-dihydroxybenzophenone, 2,4,4'-trihydroxybenzophenone, 2,2',4,4'-tetrahydroxybenzophenone, dimethyl 4-hydroxyphthalate, methyl 4-hydroxybenzoate, ethyl 4-hydroxybenzoate, propyl 4-hydroxybenzoate, sec-butyl 4-hydroxybenzoate, pentyl 4-hydroxybenzoate, phenyl 4-hydroxybenzoate, benzyl 4-hydroxybenzoate, tolyl 4-hydroxybenzoate, chlorophenyl 4-hydroxybenzoate, phenylpropyl 4-hydroxybenzoate, phenetyl 4-hydroxybenzoate, p-chlorobenzyl 4-hydroxybenzoate, p-methoxybenzyl 4-hydroxybenzoate, novolak phenol resin, phenol polymers and the like; aromatic carboxylic acids such as benzoic acid, p-tert-butylbenzoic acid, trichlorobenzoic acid, terephthalic acid, 3-sec-butyl-4-hydroxybenzoic acid, 3-cyclohexyl-4-hydroxybenzoic acid, 3,5-dimethyl-4-hydroxybenzoic acid, salicylic acid, 3-isopropylsalicylic acid, 3-benzylsalicylic acid, 3-(α-methylbenzyl)salicylic acid, 3-chloro-5-(α-methylbenzyl)salicylic acid, 3,5-di-tert-butylsalicylic acid, 3-phenyl-5-(α,α-dimethylbenzyl)salicylic acid, 3,5-di(α-methylbenzyl)salicylic acid and the like; and salts of the above phenolic compounds or aromatic carboxylic acids with polyvalent metals such as zinc, magnesium, aluminium, calcium, titanium, manganese, tin and nickel.

There can further be used 4-hydroxydiphenylsulfone derivatives such as 4,4'-dihydroxydiphenylsulfone, 3,3'-dipropenyl-4,4'-dihydroxydiphenylsulfone, 4-hydroxy-4'-chlorodiphenylsulfone, 4-hydroxy-4'-methyldiphenylsulfone, 4-hydroxy-3'4'-dimethyldiphenylsulfone, 4-hydroxy-4'-ethyldiphenylsulfone, 4-hydroxy-4'-tert-butyldiphenylsulfone, 4-hydroxy-4'-n-octyldiphenylsulfone, 4-hydroxy-4'-n-octyldiphenylsulfone, 4-hydroxy-4'-methoxydiphenylsulfone, 4-hydroxy-4'-ethoxydiphenylsulfone, 4-hydroxy-4'-isopropyloxydiphenylsulfone, 4-hydroxy-4'-n-butoxydiphenylsulfone, 4-hydroxy-4'-tert-butoxydiphenylsulfone, 4-hydroxy-4'-isoamyloxydiphenylsulfone, 4-hydroxy-4'-n-octyloxydiphenylsulfone, 4-hydroxy-4'benzyloxydiphenylsulfone, 4-hydroxy-4'-phenoxydiphenylsulfone, 3',4'-trimethylene-4-hydroxydiphenylsulfone, 3',4'-trimethylene-2,6-dimethyl-4-hydroxydiphenylsulfone, 3',4'-tetramethylene-4-hydroxydiphenylsulfone, 3',4'-tetramethylene-2-methyl-4-hydroxydiphenylsulfone and the like.

4-hydroxybenzenesulfonylnaphthalenes may be used as colour developers. They include 1-(4-hydroxybenzenesulfonyl)naphthalene, 1-(4-hydroxybenzenesulfonyl)-4-methylnaphthalene, 1-(4-hydroxybenzenesulfonyl)-4-methoxynaphthalene, 1-(4-hydroxybenzenesulfonyl)-4-chloronaphthalene, 1-(4-hydroxy-2-methylbenzenesulfonyl)naphthalene, 1-(4-hydroxy-2-chlorobenzenesulfonyl)naphthalene, 1-(4-hydroxybenzenesulfonyl)-2,-dimethylnaphthalene, 1-(4hydroxybenzenesulfonyl)-4-hydroxynaphthalene, 1-(4-hydroxybenzenesulfonyl)-2-hydroxynaphthalene, 1-(4-hydroxy-2-isopropylbenzenesulfonyl)naphthalene, 1-(4-hydroxy-2-isoamylbenzenesulfonyl)naphthalene, 1-(4-hydroxy-2-isopropyloxybenzenesulfonyl)-naphthalene, 1-(4-hydroxybenzenesulfonyl)-4-tert-butoxynaphthalene, 1-(4-hydroxy-2-benzyloxybenzenesulfonyl)naphthalene, 1-(4-hydroxy-2-phenoxybenzenesulfonyl)naphthalene, 2-(4-hydroxybenzene sulfonyl)naphthalene and the like.

Halophthalic acid monoesters can also be used. Examples are monomethyl ester, monoethyl ester, monocyclopentyl ester, monoallyl ester, monobenzyl ester, mono-p-methylbenzyl ester, mono-p-chlorobenzyl ester, monophenethyl ester, monophenyl ester, mono-p-methylphenyl ester, mono-2,4-dimethylphenyl ester, mono-p-chlorophenyl ester, mono-p-ethoxyphenyl ester, mono-1-naphthyl ester, mono-2-naphthyl ester, mono-2-hydroxyethyl ester, mono-2-hydroxybutyl ester, mono-3-hydroxybutyl-2-ester, mono-2-(2-hydroxyethoxy)ethyl ester, mono-2-hydroxypropyl ester, mono-4-hydroxybutenyl ester, mono-4-hydroxybutyl ester, mono-2-hydroxycyclohexyl ester, mono-4-hydroxycyclohexyl ester and mono-2,3-dihydroxypropyl ester of halophthalic acids, such as 4 (or 5)-fluorophthalic acid, 4 (or 5)-chlorophthalic acid, 4 (or 5)-bromophthalic acid, 3,6 (or 4,5)-dicholorophthalic acid, 3,6 (or 4,5)-dibromophthalic acid, 3,4,5,6-tetrafluorophthalic acid, 3,4,5,6,-tetra chlorophthalic acid, 3,4,5,6-tetrabromophthalic acid and the like. Among the polyvalent metal compounds which form polyvalent metal salts with the above esters, there are included magnesium, calcium, barium, zinc, aluminium, tin, iron, cobalt, nickel and the like. Preferable metals are magnesium, calcium, barium and zinc.

Further suitable colour developers are disclosed in e.g. US-P-4.803.148, EP-A-302529, DE-A-3.807.744, DE-A-3.942.227, DE-A-3.810.207, US-P4.753.759 and the references cited therein.

According to the most preferred embodiment of the present invention the dye precursor and colour developer are arranged in separate layers on the support of the imaging element. As binders for these layers there can be used e.g. polyesters, polyamides, e.g. N-methoxymethyl polyhexamethylene adipamide, vinylidene chloride copolymers, e.g. vinylidene chloride/acrylonitrile, vinylidene chloride/methylacrylate and vinylidene chloride/vinylacetate copolymers etc., ethylene/vinyl acetate copolymers, cellulosic ethers, e.g. methyl cellulose, ethyl cellulose and benzyl cellulose, polyethylene, synthetic rubbers, e.g. butadiene/acrylonitrile copolymers, and chloro-2-butadiene-1,3 polymers, cellulose esters, e.g. cellulose acetate, cellulose acetate succinate and cellulose acetate butyrate, cellulose nitrate, polyvinyl esters, e.g. polyvinyl acetate/acrylate, polyvinyl acetate/methacrylate and polyvinyl acetate, polyacrylate and alpha-alkyl polyacrylate esters, e.g. polymethyl methacrylate and polyvinyl acetate, high molecular weight polyethylene oxides of polyglycols having average molecular weights from about 4,000 to 1,000,000, polyvinyl chloride and copolymers, e.g. polyvinyl chloride/acetate, polyvinylchloride/acetate/alkohol, polyvinyl acetal, e.g. polyvinyl butyral, polyvinyl formal, polyformaldehydes, polyurethanes and copolymers, polycarbonate and copolymers, polystyrenes and copolymers e.g. polystyrene/acrylonitrile, polystyrene/acrylonitrile/butadiene, polyvinyl alcohol, cellulose, anhydrous gelatin, phenolic resins and melamine-formaldehyde resins etc., or mixtures of one ore more of the above polymers.

The layer containing the dye precursor will be preferably free of polymers containing acid groups and phenolic groups. It is further preferred that the softening temperature of both layers is well above ambient temperature, preferably above 40°C and more preferably above 60°C. The layers containing the dye precursor or colour developer can also contain immiscible polymeric or non-polymeric organic or inorganic fillers or reinforcing agents which are essentially colorless e.g. the organophilic silicas, bentonites, silica, powdered glass, TiO₂, ZnO₂ etc..

Suitable supports for the imaging element in connection with the present invention are supports that are stable at the heating temperatures used for image-wise or overall heating the imaging element in accordance with one of the above described methods. Examples of useful supports are e.g. polyester film supports e.g. polyethylene terephthalate, glass, wood, paper, polyethylene coated paper, cellulose esters e.g. cellulose acetate, cellulose propionate, cellulose butyrate, poly carbonate, polyvinyl chloride, polyimide, polypropylene etc.

The layer or layers containing the dye precursor and acid developer may be adhered to the support by an adhesive layer.

The support may be coated with an anti-static coating on one or both sides of the support.

According to a variant of the most preferred embodiment of the present invention there can be provided a so-called barrier layer between the layers containing respectively the dye precursor and colour developer. Such barrier layer will help improve the stability of the image by further separating the dye precursor from the colour developer. Preferably such barrier layer will have a softening and or melting temperature below that of the two other layers and preferably above 30°C and more preferably above 40°C.

In the imaging element there may also be included additional polymerizable monomers preferably urethane type monomers e.g. as disclosed in the German patent applications numbers 3,522,005, 3,703,080, 3,643,216, 3,703,130, 3,917,320 and 3,743,728.. These monomers may be included in a layer containing the polymerizable colour developer and/or dye precursor or they may be included in the above described barrier layer.

A preferred polymerizable monomer has a general formula: 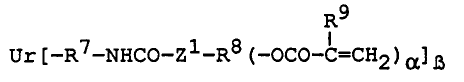 wherein
- Ur: represents a divalent or trivalent condensed urea residue ;
- Z¹: represents O or NR¹⁰ with R¹⁰ representing alkyl containing 1 to 12 C-atoms ;
- R⁷: represents a divalent hydrocarbon residue containing 2 to 25 C-atoms ;
- R⁸: represents a hydrocarbon residue with a valence between 2 and 6, and containing 2 to 18 C-atoms, which can be linear or branched and which can be interrupted by upto 3 O atoms ;
- R⁹: represents hydrogen or methyl ;
- α: represents an integer from 1 to 5, and
- β: equals 2 or 3.

In general formula (II) preferred condensed urea residues represented by Ur are following structural units :

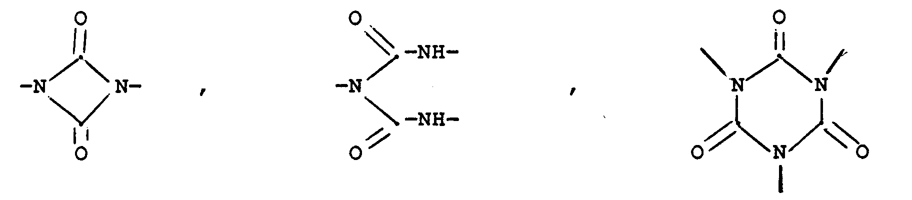

Preferably the divalent residue represented by Z¹ is an oxygen atom. In the case Z¹ represents NR¹⁰, then R¹⁰ is preferably a linear or branched alkyl group, e.g. methyl, ethyl, propyl or t.butyl.

The hydrocarbon residue represented by R⁷ may be interrupted by oxygen. R⁷ represents aliphatic, aromatic or mixed aliphatic-aromatic hydrocarbon residues. For example, R⁷ equals a divalent linear or branched aliphatic group, preferably having 2 to 12 carbon atoms, e.g. ethylene, propylene, 1,4-tetramethylene, 1,6-hexamethylene and 2,2,4-trimethyl-1,6-hexamethylene and their isomers. Alternatively R⁷ may represent a monocyclic or polycyclic saturated or aromatic hydrocarbon residue having 6 to 24, and preferably 6 to 14 carbon atoms.

Examples of preferred useful monomers according to general formula (II) are listed below:

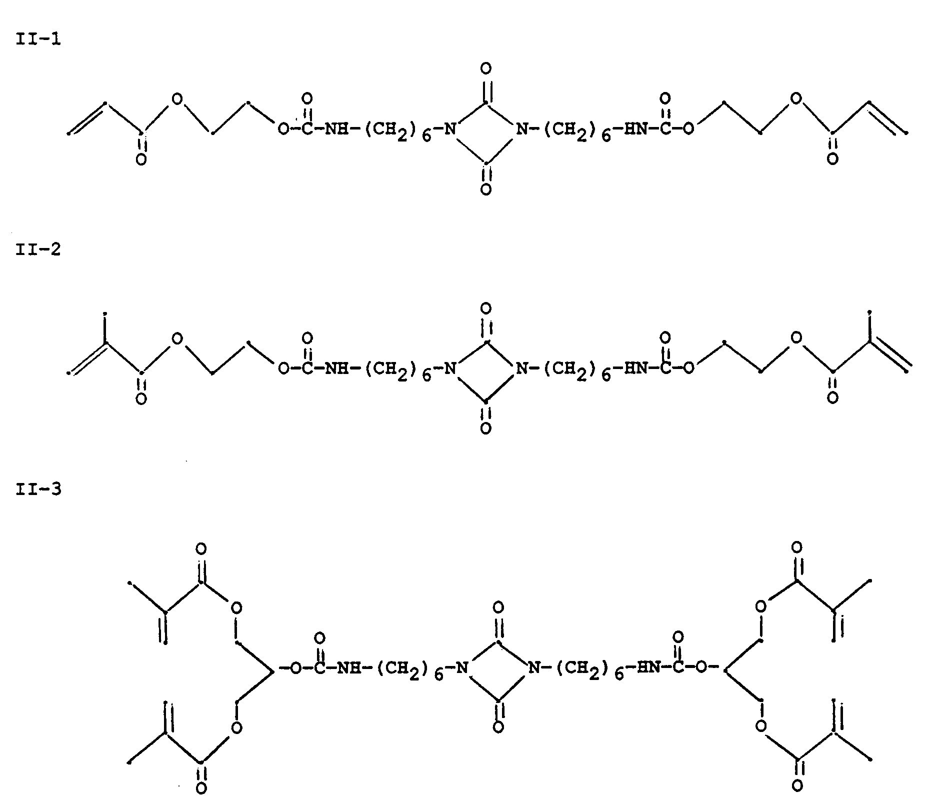

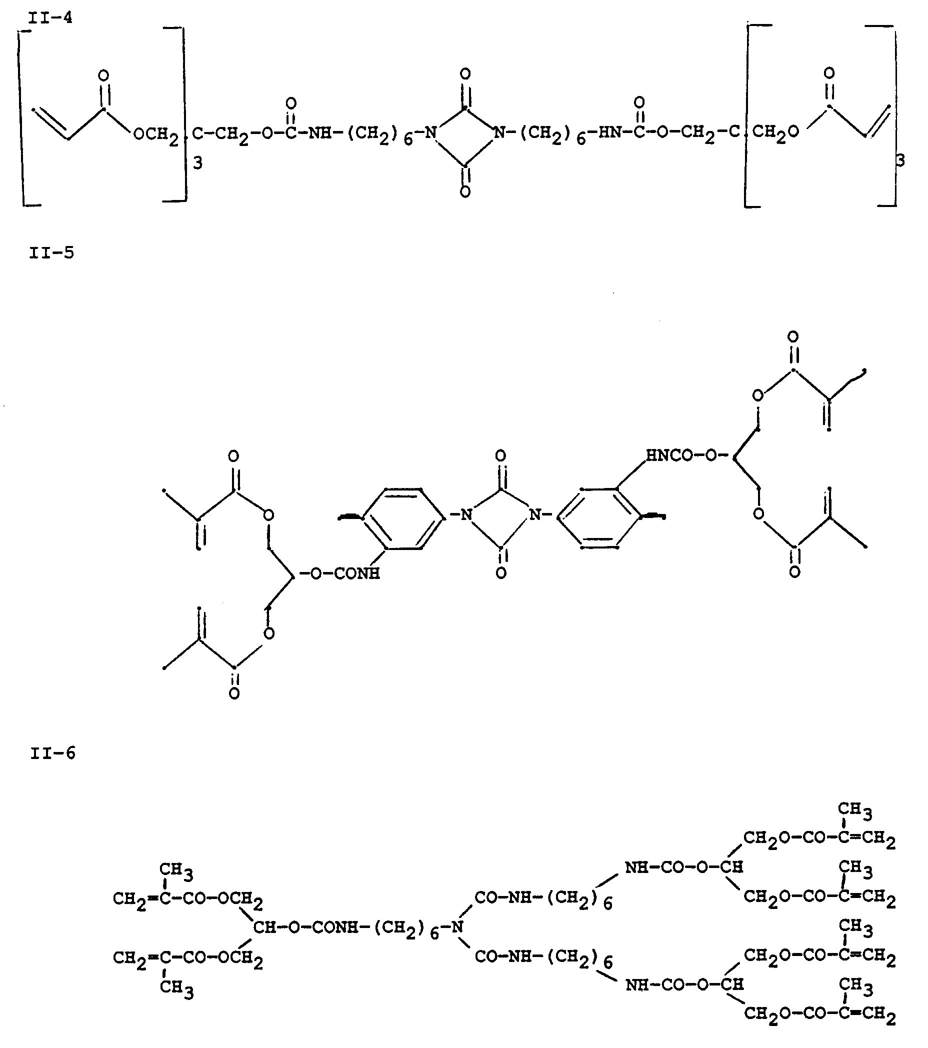

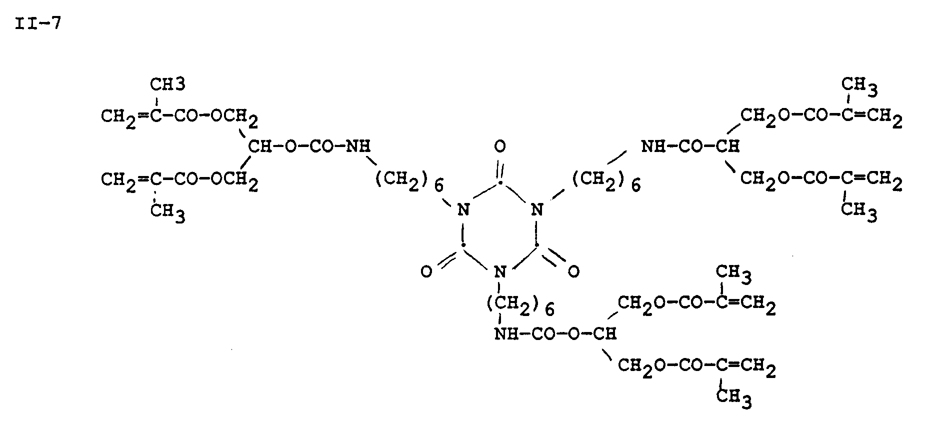

One monomer or a mixture of more than one monomer according to formulae (II) can be used. Further the monomers corresponding to general formulae (II) may be mixed with other polymerizable ethylenically unsaturated compounds. However when besides the polymerizable acid developer other polymerizable monomers are present at least 60% thereof is preferably made up by monomers according to the above formulae (II). Suitable polymerizable ethylenically unsaturated compounds which can be used in accordance with the present invention are e.g. unsaturated esters of polyols, particularly such esters of the alpha-methylene carboxylic acids, e.g. ethylene diacrylate, glycerol tri(meth)acrylate, ethylene dimethacrylate, 1,3-propanediol di(meth)acrylate 1,2,4-butanetriol tri(meth)acrylate, 1,4-cyclohexanediol di(meth)acrylate, 1,4-benzenediol di(meth)acrylate, pentaerythritol tetra(meth)acrylate, 1,5-pentanediol di(meth)acrylate, the bis acrylates and methacrylates of polyethylene glycols of molecular weight 200-500, and the like : unsaturated amides, particularly those of the alphamethylene carboxylic acids, and especially those of alpha-omega-diamines and oxygen-interrupted omega-diamines, such as methylene bis-acrylamide, methylene bis-methacrylamide, 1,6-hexamethylene bis-acrylamide, diethylene triamine tris-methacrylamide, bis(gamma-methacrylamidopropoxy)ethane, beta-methacrylamidoethyl methacrylate, N-(beta-hydroxyethyl)-beta-(methacrylamido)ethyl acrylate and N,N-bis(beta-methacrylolyoxyethyl)acrylamide; vinyl esters e.g. divinyl succinate, divinyl adipate, divinyl phthalate, divinyl butane-1,4-disulfonate; and unsaturated aldehydes, e.g. sorbaldehyde (hexadienal). Other suitable polymerizable ethylenic unsaturated compounds that can be used in accordance with the present invention are polymers and/or oligomers comprising 2 or more polymerizable functions e.g. acrylated epoxies, polyester acrylates, urethane acrylates, polyvinyl alcohol modified with a (meth)acrylic acid or (meth)acrylic acid halide etc..

The imaging element in connection with the present invention preferably also includes a photoinitiator in the layer containing the polymerizable colour developer. Preferably a photoinitiator is also added to any other layer containing a polymerizable monomer.

Preferably used photoinitiators are polymerization initiators activatable by actinic light and thermally inactive at and below 185°C. Examples of such initiators include the substituted or unsubstituted polynuclear quinones which are compounds having two intracyclic carbonyl groups attached to intracylic carbon atoms in a conjugated six-membered carbocyclic ring, there being at least one aromatic carbocyclic ring fused to the ring containing the carbonyl groups. Such initiators include 9-10-anthraquinone, 1-chloroanthraquinone, 2-chloroanthraquinone, 2-methylanthraquinone, 2-tert-butylanthraquinone, octamethylanthraquinone, 1,4-naphthoquinone, 9,10-phenanthrenequinone, 1-2 benzanthraquinone, 2,3-dichloronaphthoquinone, sodium salt of anthraquinone alpha-sulfonic acid, 3-chloro-2-methylanthraquinone, and 1,2,3,4-tetrahydrobenzene anthracene-7,12-dione. The photointiators which are also useful are described in Plambeck U.S. Patent 2,760,863 and include vicinal ketaldonyl compounds, such as diacetyl, benzil, etc. alpha-ketaldonyl alcohols, such as benzoin, pivalon, etc. acyloin ethers e.g. benzoin methyl and ethyl ethers, etc.; alpha-hydrocarbon substituted aromatic acyloins, including mehtylbenzoin, alpha-allylbenzoin, and alpha-phenylbenzoin. Still further photoinitiators useful in accordance with the present invention are those disclosed in "Photoreactive Polymers" by Arnost Reiser, "Organic photochemical imaging systems" by G.A. Delzenne, in the paper "UV-Curing Chemistry: Past, Present, and Future" by Christian Decker, published in J. of Coatings Technology, Vol.59,N° 751, August 1987, pages 97-106, in EP-A 362,827, and in US-A 3,558,309.

As the dye precursors comprised in the imaging element according to the present invention, there are exemplified triarylmethanelactone compounds such as 3,3-bis(p-dimethylaminophenyl)-6-dimethylaminophthalide, 3,3-bis(p-dimethylaminophenyl)phthalide, 3-(p-dimethylaminophenyl)3-(1,2-dimethylindole-3-yl)phthalide, 3-(p-dimethylaminophenyl)-3-(2-methylindole-3-yl)phthalide, 3,3-bis(1,2-dimethylindole-3-yl)-5-dimethylaminophthalide, 3,3-bis(1,2-dimethylindole-3-yl)-6-dimethylaminophthalide, 3,3-bis(9-ethylcarbazole-3-yl)-6-dimethylaminophthalide, 3,3-bis(2-phenylindole-3-yl)-6-dimethylaminophthalide, 3-p-dimethylaminophenyl-3-(1-methylaminophthalide and the like; diphenylmethane compounds such as 4,4-bis-dimethylaminobenzhydryl benzyl ether, N-halophenylleucoauramine, N-2,4,5-trichlorophenyl-leucoauramine and the like; thiazine compounds such as benzoyl-leucomethylene bleu, p-nitrobenzoyl-leucomethylene blue and the like; spiro compounds such as 3-methyl-spiro-dinaphthopyran, 3-ethyl-spiro-dinaphthopyran, 3-benzyl-spiro-dinaphthopyran, 3-methyl-naphtho-(6-methoxybenzo) spiropyran, 3-propyl-spiro-dibenzopyran and the like; lactam compounds such as Rhodamine-B anilinelactam, Rhodamine(p-nitroanilino) lactam, Rhodamine (o-chloroanilino) lactam and the like; and fluoran compounds such as 3-dimethylamino-7-methoxyfluoran, 3-diethylamino-6-methoxyfluoran, 3-diethylamino-7-methoxyfluoran, 3-diethylamino-6-methyl-7-chlorofluoran, 3-diethylamino-6,7-dimethylfluoran, 3-(N-ethyl-p-toluidino)-7-methylfluoran, 3-diethylamino-7-N-acetyl-N-methylaminofluoran, 3-diethylamino-7-N-methylaminofluoran, 3-diethylamino-7-dibenzylamino-7-N-methyl-N-benzylaminofluoran, 3-diethylamino-7-N-chloroethyl-N-methylaminofluoran, 3-diethylamino-7-N-diethylaminofluoran, 3-(N-ethyl-p-toluidino)-6-methyl-7-phenylaminofluoran, 3-(N-ethyl-p-toluidino)-6-methyl-7-(p-toluidino)fluoran, 3-diethylamino-6-methyl-7-phenylaminofluoran, 3-di-n-butylaminofluoran, 3-diethylamino-7-(2-carbomethoxyphenylamino)fluoran, 3-(N-cyclohexyl-N-methylamino)-6-methyl-7-phenylaminofluoran, 3-(N-cyclopentyl-N-methylamino)-6-methyl-7-phenylaminofluoran, 3-(N-cyclopentyl-N-ethylamino)-6-methyl-7-phenylaminofluoran, 3-(N-cyclohexyl-N-ethylamino)-6-methyl-7-phenylaminofluoran, 3-(N-3',3',5'-trimethylcyclohexyl-N-methylamino)-6-methyl-7-phenylaminofluoran, 3-pyrrolidino-6-methyl-7-phenylaminofluoran, 3-piperidino-6-methyl-7-phenylaminofluoran, 3-diethylamino-6-methyl-7-xylidinofluoran, 3-diethylamino-7-(o-chlorophenylamino)-fluoran, 3-dibutylamino-7-(o-chlorophenylamino)fluoran, 3-pyrrolidino-6-methyl-7-p-butylphenyl aminofluoran, 3-diethylamino-7-(o-fluorophenylamino)fluoran, 3-dibutylamino-7-(o-fluorophenylamino)fluoran, 3-(N-methyl-N-n-amyl)amino-6-methyl-7-phenylaminofluoran, 3-(N-ethyl-N-n-amyl)amino-6-methyl-7-phenylaminofluoran, 6-methyl-7-phenylaminofluoran, 3-(N-methyl-N-n-hexyl)amino-6-methyl-7-phenylaminofluoran, 3-(N-ethyl-N-n-hexyl)amino-6-methyl-7-phenylaminofluoran, 3-(N-ethyl-N-6-ethylhexyl)-amino-6-methyl-7-phenylaminofluoran, 3-(N-ethyl-N-tetrahydrofurfurylamino)-6-methyl-7-phenylfluoran and the like. Still further dye precursors for use in connection with the present intention are disclosed in e.g. US-P-4.803.148, EP-A-302529, DE-A-3.807.744, DE-A-3.942.227, DE-A-3.810.207, US-P4.753.759 and the references cited therein. The dye precursors may be used either solely or in combination.

The imaging element according to the invention may include further additional layers such as e.g. a surface layer of for example ,polyester , for protecting the imaging element against wear and scratches or subbing layers for improving the adhesion of the layers contained in the imaging element to its support.

The present invention is illustrated by the following examples without however limiting it thereto. All parts are by weight unless otherwise specified.

### EXAMPLES

The following coating solutions were used in the examples:

### Coating Solutions for Dye Precursor Layer

| Coating dye solution A (methyl ethyl ketone): | |
|---|---|
| Leuco dye L-1 | 5.00% |
| Copoly(vinyl chloride/vinyl acetate) (SOLVIC™ 560 RA, marketed by Solvay) | 5.00% |

| Coating dye solution B (methyl ethyl ketone): | |
|---|---|
| Leuco dye L-1 | 5.00% |
| Copoly(vinyl chloride/vinyl acetate) (SOLVIC™ 560 RA, Solvay) | 3.00% |
| Monomer II-7 (see above) | 2.00% |
| Benzil dimethyl ketal (IRGACURE™ 651, marketed by Ciba-Geigy) | 0.30% |

| Coating dye solution C (methyl ethyl ketone): | |
|---|---|
| Leuco dye L-2 | 5.00% |
| Copoly(vinyl chloride/vinyl acetate) (SOLVIC™ 560 RA, Solvay) | 3.00% |
| Monomer II-7 (see above) | 2.00% |
| Benzil dimethyl ketal (IRGACURE™ 651, Ciba-Geigy) | 0.30% |

### Barrier Layer

| Polymer coating D (water) | |
|---|---|
| A solution of Polyvinyl alcohol, in which 25% of the hydroxyl groups had reacted with methacryloyl chloride | 5.00% |

| Polymer coating E (water) | |
|---|---|
| A dispersion of Polyvinylidene chloride copolymer (IXAN™ WA36) | 5.00% |

### Coatings for the developer layer

| Developer Coating F (methyl ethyl ketone) | |
|---|---|
| Acid S-1 (see above) | 5.00% |
| Copoly(vinyl chloride/vinyl acetate) (SOLVIC™ 560RA, Solvay) | 1.00% |
| Monomer II-7 (see above) | 3.00% |
| Benzil dimethyl ketal (IRGACURE™ 651, Ciba-Geigy) | 1.00% |

| Developer coating G (methyl ethyl ketone) | |
|---|---|
| Acid S-1 (see above) | 5.00% |
| Monomer II-7 (see above) | 3.00% |
| Benzil dimethyl ketal (IRGACURE™ 651, Ciba-Geigy) | 1.60% |

| Developer coating H (methyl ethyl ketone) | |
|---|---|
| Acid S-2 (see above) | 2.50% |
| Monomer II-7 (see above) | 1.50% |
| Benzil dimethyl ketal (IRGACURE™ 651, Ciba-Geigy) | 0.80% |

| Developer coating I (methyl ethyl ketone) | |
|---|---|
| Acid S-3 (see above) | 4.00% |
| Monomer II-7 (see above) | 3.00% |
| Benzil dimethyl ketal (IRGACURE™ 651, Ciba-Geigy) | 1.60% |

### Formula of the components used

### Leuco dye L-1

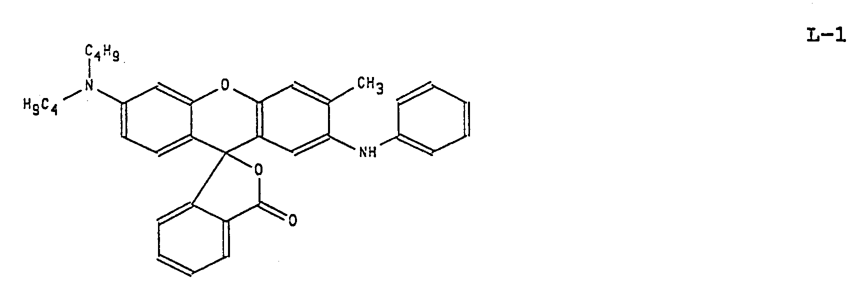

### Leuco dye L-2

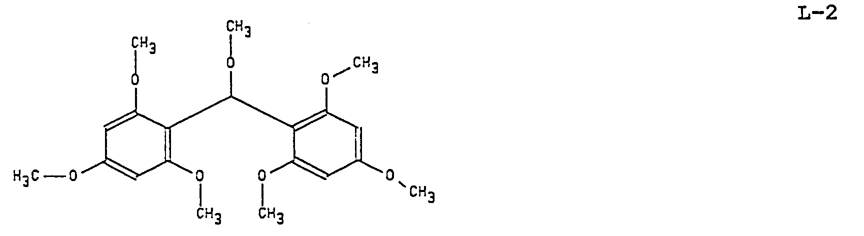

### Photoinitiator

Irgacure™ 651:

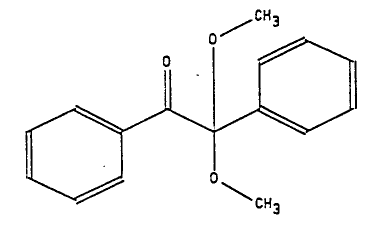

### Preparations 1 - 8

The leuco dye coating with a wet film thickness of 100µm and the polymer solution (and polymer dispersion resp.), if stated below, with a wet film thickness of 10µm were coated in the described order on a polyethylene terephthalate base having a thickness of 63µm and dried at 50°C. The developer coating was coated with a wet film thickness of 50µm on a further polyethylene terephthalate base with a thickness of 5µm. Both bases were used to make a laminate at ambient temperature by means of a web-fed laminator in which the coated faces of both bases were in contact. All operations proceeded in a darkroom with red safelight.

| Preparation no. | Leuco dye coating | Polymer solution/dispersion | Developer Coating |
|---|---|---|---|
| 1 | A | - | F |
| 2 | B | - | F |
| 3 | B | E | G |
| 4 | C | D | G |
| 5 | C | E | H |
| 6 | C | D | H |
| 7 | C | D | I |
| 8 | B | D | I |

### Evaluation as light-sensitive material

The laminates were exposed in DUPLIPHOT™ HS 130 exposure unit through a test original with an exposure setting of 700. The test original was selected in a way to allow an evaluation of line definition, dot reproduction and edge sharpness, as well as a determination of density on both exposed and unexposed areas. After exposure the laminate was heated to 120°C for 60 s. An inverted image was obtained. Line definition, dot reproduction and edge sharpness were very good for all preparations. Densities were measured by transmitted light on the unexposed (= Dmax) and the exposed (= Dmin) areas.

| Preparation no. | Dmax | Dmin |
|---|---|---|
| 1 | 1.75 | 0.11 |
| 2 | 1.71 | 0.06 |
| 3 | 2.36 | 0.09 |
| 4 | 1.73 | 0.15 |
| 5 | 1.54 | 0.19 |
| 6 | 2.21 | 0.24 |
| 7 | 2.05 | 0.12 |
| 8 | 1.93 | 0.07 |

The samples were then stored at 60°C for six days and the Dmax of the imaged areas was again measured for comparison with the original value . No deterioration of image quality was found.

### Evaluation as heat-sensitive material

The laminate of preparation 3 was image-wise printed by means of a commercially available thermoprinter (HITACHI VY-100™). The maximum density Dmax measured by transmitted light was 1.90. Image sharpness and density graduation were good. For subsequent fixing the image was exposed in a DUPLIPHOT™ HS 130 exposure unit with exposure setting of 700. For image stability tests the image was kept in a conditioner at 60°C for 6 days. No deterioration of image quality was found.

Thus it can be seen from the samples that the inclusion of a photopolymerizable acid developer in the developer layer gives an image of high stability when exposed to light radiation first or to heat imaging first.

## Claims

1. An imaging element comprising a dye precursor and an acidic colour developer arranged on a support in the same layer or in separate layers characterised in that the acid developer includes at least 50% by weight polymerizable organic acid and the layer containing the polymerizable organic acid further including a photo-initiator.

2. An imaging element according to Claim 1, characterised in that the polymerizable organic acid is polymerizable by a free radical polymerization process.

3. An imaging element according to Claim 2, characterised in that the polymerizable acid has a formula 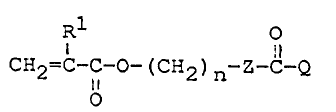 wherein R1 represents hydrogen or a methyl group, Z represents -O-or -NR- with R an alkyl group having 1 to 4 carbon atoms and Q represents an aromatic ring substituted with at least two -COOH groups and which carboxyl groups may be in the form of an anhydride.

4. An imaging element as claimed in any one of claims 1 to 3, characterised in that the acid developer comprises a single polymerizable organic acid.

5. An imaging element as claimed in any one of Claims 1 to 4, characterised in that the dye precursor and colour developer are arranged in separate layers.

6. An imaging element as claimed in Claim 5, characterised in that a barrier layer is provided between the layers containing the dye precursor and the layer containing the colour developer.

7. An imaging element as claimed in any one of Claims 1 to 6, characterised in that the layer containing the polymerizable acid also contains a further polymerizable monomer.

8. An imaging element as claimed in Claim 5 or Claim 6 or Claim 7, characterised in that the layer containing the dye precursor also contains a polymerizable monomer.

9. An imaging element as claimed in any one of Claim 6 and Claims 7 and 8 when dependant upon Claim 6, characterised in that the barrier layer includes a polymerizable monomer.

10. A method of imaging an imaging element as claimed in any one of claims 1 to 9, said method being characterised in that the imaging element is exposed to actinic radiation thereby causing polymerization of the acid in the exposed areas, and then heated to cause reaction between the dye precursor and the colour developer in the area unexposed to actinic radiation.

11. A method of imaging an imaging element as claimed in any one of Claims 1 to 9, said method being characterised in that the imaging element is first exposed to heat forming a coloured image in the exposed areas, and then exposed overall to actinic radiation.

## Patentansprüche

1. Ein Aufzeichnungselement, das auf einem Träger einen Farbstoffvorläufer und einen Säurefarbentwickler enthält, die in derselben Schicht oder in separaten Schichten enthalten sind, dadurch gekennzeichnet, daß der Säureentwickler wenigstens 50 Gew.-% polymerisierbare organische Säure enthält und die die polymerisierbare organische Säure enthaltende Schicht weiterhin einen Fotoinitiator enthält.

2. Ein Aufzeichnungselement nach Anspruch 1, dadurch gekennzeichnet, daß die polymerisierbare organische Säure durch einen Radikalmechanismus polymerisiert wird.

3. Ein Aufzeichnungselement nach Anspruch 2, dadurch gekennzeichnet, daß die polymerisierbare Säure der folgenden Formel entspricht : 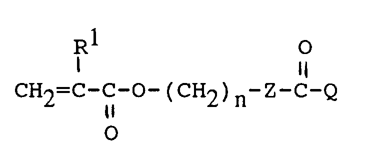 in der R¹ Wasserstoff oder eine Methylgruppe, Z -O- oder -NR-, wobei R eine Alkylgruppe mit 1 bis 4 Kohlenstoffatomen bedeutet, und Q einen aromatischen, mit wenigstens zwei -COOH-Gruppen substituierten Ring bedeutet, wobei die Carboxylgruppen in Form eines Anhydrids vorliegen können.

4. Ein Aufzeichnungselement nach irgendeinem der Ansprüche 1 bis 3, dadurch gekennzeichnet, daß der Säureentwickler eine einzige polymerisierbare organische Säure enthält.

5. Ein Aufzeichnungselement nach irgendeinem der Ansprüche 1 bis 4, dadurch gekennzeichnet, daß der Farbstoffvorläufer und der Farbentwickler in separaten Schichten angeordnet sind.

6. Ein Aufzeichnungselement nach Anspruch 5, dadurch gekennzeichnet, daß zwischen die Farbstoffvorläuferschicht und die Farbentwicklerschicht eine Sperrschicht eingearbeitet ist.

7. Ein Aufzeichnungselement nach irgendeinem der Ansprüche 1 bis 6, dadurch gekennzeichnet, daß die die polymerisierbare Säure enthaltende Schicht weiterhin ein zusätzliches polymerisierbares Monomeres enthält.

8. Ein Aufzeichnungselement nach Anspruch 5, 6 oder 7, dadurch gekennzeichnet, daß daß die den Farbstoffvorläufer enthaltende Schicht ebenfalls ein polymerisierbares Monomeres enthält.

9. Ein Aufzeichnungselement nach irgendeinem des Anspruchs 6 und der als Unteranspruch des Anspruches 6 geltenden Ansprüche 7 und 8, dadurch gekennzeichnet, daß die Sperrschicht ein polymerisierbares Monomeres enthält.

10. Ein Verfahren zur Bildaufzeichnung auf einem wie in irgendeinem der Ansprüche 1 bis 9 beschriebenen Aufzeichnungselement, wobei das Aufzeichnungselement bildmäßig an aktinische Strahlung belichtet, wodurch die Säure in den belichteten Bereichen polymerisiert wird, und danach erwärmt wird, wodurch der Farbstoffvorläufer und der Farbentwickler im nicht an aktinische Strahlung belichteten Bereich miteinander reagieren werden.

11. Ein Verfahren zur Bildaufzeichnung auf einem wie in irgendeinem der Ansprüche 1 bis 9 beschriebenen Aufzeichnungselement, wobei das Aufzeichnungselement zunächst mit Wärme belichtet, wobei in den belichteten Bereichen ein Farbbild erstellt wird, und dann einer Gesamtbelichtung an aktinische Strahlung unterzogen wird.

## Revendications

1. Elément formateur d'image comprenant un précurseur de colorant et un révélateur chromogène acide arrangés sur un support dans la même couche ou dans des couches séparées, caractérisé en ce que le révélateur acide englobe au moins 50% en poids d'acide organique polymérisable, et la couche contenant l'acide organique polymérisable englobe en outre un photoinitiateur.

2. Elément formateur d'image selon la revendication 1, caractérisé en ce que l'acide organique polymérisable est apte à polymériser à l'aide d'un procédé de polymérisation radicalaire.

3. Elément formateur d'image selon la revendication 2, caractérisé en ce que l'acide polymérisable répond à la formule 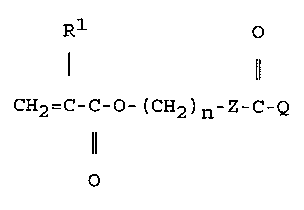 dans laquelle R¹ représente un atome d'hydrogène ou un groupe méthyle, Z représente -O- ou -NR- où R représente un groupe alkyle contenant de 1 à 4 atomes de carbone, et Q représente un noyau aromatique substitué avec au moins deux groupes -COOH et dont les groupes carboxyle peuvent être présents sous la forme d'un anhydride.

4. Elément formateur d'image selon l'une quelconque des revendications 1 à 3, caractérisé en ce que le révélateur acide comprend un seul acide organique polymérisable.

5. Elément formateur d'image selon l'une quelconque des revendications 1 à 4, caractérisé en ce que le précurseur de colorant et le révélateur chromogène sont arrangés dans des couches séparées.

6. Elément formateur d'image selon la revendication 5, caractérisé en ce qu'on procure une couche d'arrêt entre les couches contenant le précurseur de colorant et la couche contenant le révélateur chromogène.

7. Elément formateur d'image selon l'une quelconque des revendications 1 à 6, caractérisé en ce que la couche contenant un acide polymérisable contient également un monomère polymérisable supplémentaire.

8. Elément formateur d'image selon la revendication 5 ou 6 ou 7, caractérisé en ce que la couche contenant le précurseur de colorant contient également un monomère polymérisable.

9. Elément formateur d'image selon l'une quelconque des revendications 6 et 7 et 8 lorsqu'elles dépendent de la revendication 6, caractérisé en ce que la couche d'arrêt englobe un monomère polymérisable.

10. Procédé de formation d'image à l'aide d'un élément formateur d'image selon l'une quelconque des revendications 1 à 9, ledit procédé étant caractérisé en ce qu'on expose l'élément formateur d'image à un rayonnement actinique, ce qui provoque la polymérisation de l'acide dans les zones exposées et ensuite, on le chauffe pour provoquer la réaction entre le précurseur de colorant et le révélateur chromogène dans la zone non exposée au rayonnement actinique.

11. Procédé de formation d'image à l'aide d'un élément formateur d'image selon l'une quelconque des revendications 1 à 9, ledit procédé étant caractérisé en ce que l'élément formateur d'image est d'abord exposé à la chaleur pour former une image colorée dans les zones exposées, puis exposé globalement à un rayonnement actinique.
